# DEMANDE DE BREVET EUROPEEN

(11) **EP 0 795 907 A1**
(43) Date de publication de la demande: **17.09.1997**
(21) Numéro de dépôt: 97400331.1
(22) Date de dépôt: 13.02.1997
(51) Int. Cl.: H01L 23/66

(54) **Circuit hyperfréquence multicouches à éléments actifs intégrés**

(30) Priorité: 14.03.1996 FR 9603237
(71) Demandeur: DASSAULT ELECTRONIQUE, F-92210 Saint-Cloud (FR)
(72) Inventeur: Ledain, Bernard, 91190 Gif sur Yvette (FR); Herblot, Jean-Luc, 78370 Plaisir (FR)
(74) Mandataire: Plaçais, Jean-Yves

(57) **Abrégé**

Un circuit hyperfréquence comprend un empilement de couches diélectriques (Di), avec au moins une couche conductrice formant plan-masse (PMj). Des liaisons conductrices (SMk) sont prévues en au moins un niveau d'interface entre couches diélectriques (Di). L'empilement contient plusieurs plans-masse (PM1-PM5), alternés avec plusieurs niveaux de liaisons conductrices (SM1-SM4), chaque niveau de liaisons conductrices se trouvant ainsi pris en sandwich entre deux plans-masse. Des dégagements (E) découvrant un niveau de liaisons conductrices (SM4) sont également prévus en partie supérieure de l'empilement, chaque dégagement étant conformé pour loger opérativement au moins un composant électronique passif et/ou une puce d'élément actif, dont les entrées/sorties et l'alimentation proviennent de niveaux inférieurs de liaisons de l'empilement, atteints par des trous métallisés (MHp), lesquels traversent des plans-masse (Pmj) au niveau d'épargnes de ceux-ci.

## Description

L'invention concerne les circuits hyperfréquences.

On sait que les circuits hyperfréquence, ou micro-ondes, font appel à des technologies particulières, qui sont très différentes de celles des plus basses fréquences. En effet, il faut d'abord utiliser des conducteurs de forme particulière; il est également nécessaire de tenir compte des effets importants de rayonnement, désirés ou non; il est souhaitable enfin de limiter la taille des conducteurs, notamment pour limiter les pertes, tout en maîtrisant mieux les temps de propagation.

Les principales structures miniatures connues pour des lignes de transmission sont celles dites micro-ruban ("microstrip"), ou tri-plaque ("stripline"). Là où des composants électroniques sont nécessaires, le mieux est de recourir aux circuits intégrés hybrides hyperfréquence, ce qui est encore une autre technologie. Les liaisons doivent souvent faire intervenir des connecteurs hyperfréquence coaxiaux, notamment chaque fois que des contraintes topologiques et/ou technologiques empêchent un couplage direct.

Il résulte de ce qui précède que la conception des circuits hyperfréquence actuels est soumise d'abord à l'impératif fondamental de bon fonctionnement, tandis que les besoins tels que la miniaturisation ne sont qu'incomplètement satisfaits.

La présente invention vient améliorer la situation.

Le circuit hyperfréquence proposé est du type connu comprenant un empilement de couches diélectriques, avec au moins une couche conductrice formant plan-masse, tandis que sont prévues des liaisons conductrices, en au moins un niveau d'interface entre couches diélectriques.

Selon un aspect de l'invention, d'une part, l'empilement contient plusieurs plans-masse, alternés avec au moins deux niveaux de liaisons conductrices, chaque niveau de liaisons conductrices se trouvant ainsi pris en sandwich entre deux plans-masse, et d'autre part, on prévoit au moins un premier dégagement découvrant un niveau de liaisons conductrices et conformé pour loger opérativement au moins un composant électronique passif et/ou une puce d'élément actif dont la ou les entrées/sorties et l'alimentation proviennent de niveaux intermédiaires de liaisons conductrices de l'empilement, atteints par des trous métallisés qui traversent des plans-masse au niveau d'épargnes de ceux-ci.

Le composant passif peut être une capacité, une inductance, un mélangeur à diodes, une résistance gravée, ou encore un filtre interdigité. Par ailleurs, la puce active peut être un ASIC de commande.

De préférence, les composants électroniques et/ou les puces sont collées sur la couche diélectrique sur laquelle elles reposent, celle-ci étant avantageusement en un matériau thermoplastique en résine fluorocarbonée, du type verre polytétrafluoroéthylène (PTFE) ou éthylène-propylène fluoré (FEP), et de préférence de type 6002 (plus connu sous le nom commercial RT DUROID). Mais, on peut également envisager d'intercaler entre la puce et la couche diélectrique de support, une portion de couche conductrice/isolante de type céramique, ce qui procure un niveau d'interconnexion supplémentaire.

Selon une autre caractéristique de l'invention, le dispositif peut comprendre en outre au moins un second dégagement découvrant un niveau de liaison conductrice différent du niveau découvert par le premier dégagement et conformé pour loger opérativement des moyens de connexion à une alimentation destinée à alimenter la puce d'élément actif, et/ou tout autre composant, par des trous métallisés qui traversent des plans-masse au niveau d'épargnes de ceux-ci.

Dans un premier mode de réalisation, le dispositif comprend au moins trois niveaux de liaisons conductrices, pris en sandwich entre quatre plans-masse.

Dans un second mode de réalisation, le dispositif comprend deux niveaux de liaisons conductrices, pris en sandwich entre trois plans-masse, dont des plans-masse inférieur et supérieur forment, préférentiellement, respectivement parois inférieure et supérieure d'un boîtier en aluminium, et un plan-masse intermédiaire. Une telle solution permet de réaliser un boîtier de type "tout intégré".

D'autres caractéristiques et avantages de l'invention apparaîtront à l'examen de la description détaillée ci-après, ainsi que des dessins annexés, sur lesquels :
- la figure 1 est une coupe schématique de principe d'un circuit hyperfréquence multicouches selon la présente invention, dans un premier mode de réalisation;
- la figure 2 montre comment l'on peut implanter une puce de circuit hyperfréquence actif dans une structure du type de celle de la figure 1;
- la figure 3 est un diagramme de principales étapes de fabrication d'un circuit hyperfréquence multicouches tel que proposé;
- la figure 4 est une coupe schématique de principe d'un circuit hyperfréquence multicouches selon la présente invention, dans un second mode de réalisation permettant la fabrication de boîtiers "tout intégré";
- la figure 5 montre comment l'on peut implanter plusieurs puces de circuit hyperfréquence actif et une connexion d'alimentation dans une structure du type de celle de la figure 4; et
- la figure 6 illustre une vue agrandie de la zone d'implantation de l'une des puces de circuit hyperfréquence actif de la figure 5.

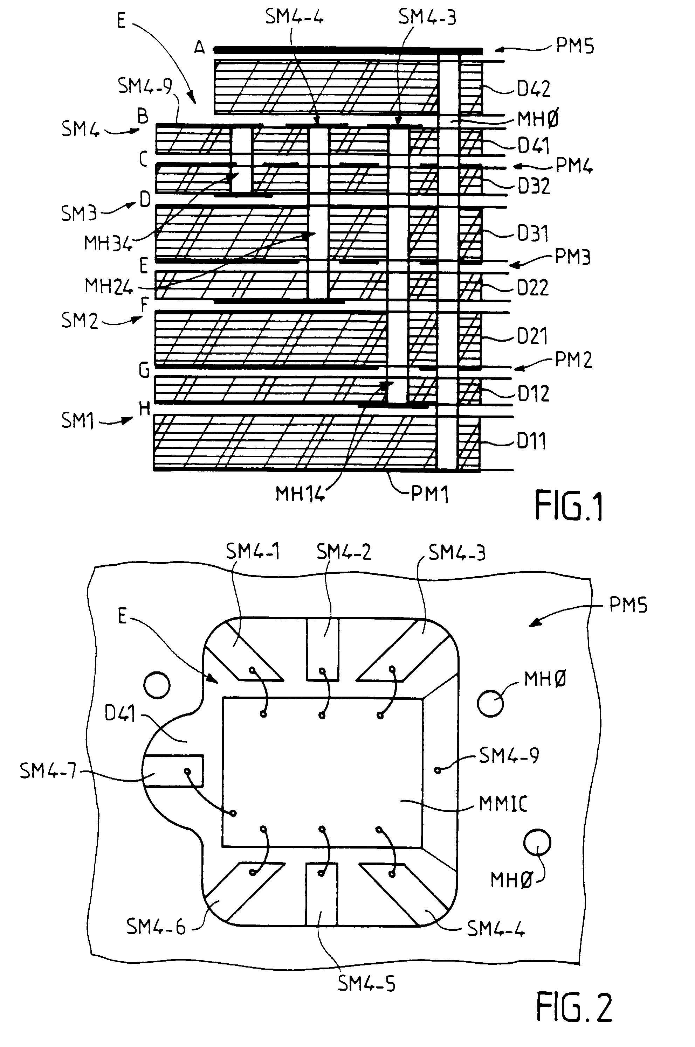

La figure 1, qui illustre un premier mode de réalisation de l'invention, sera maintenant décrite, de bas en haut.

Une première couche diélectrique D11 porte en partie basse un plan-masse PM1, défini par une métallisation surajoutée à la couche. Entre la couche D11 et une seconde couche diélectrique D12 est placé un niveau de métallisation sélective SM1, qui pourra servir de ligne de liaison. Une troisième couche diélectrique D21 porte en partie inférieure un plan-masse PM2, évidé pour former des épargnes là où il est traversé par des trous métallisés tels que MH14.

A partir du plan-masse PM2, la structure se répète ensuite avec la couche diélectrique D21, le niveau de métallisation sélective SM2, la couche diélectrique D22, et le plan-masse PM3.

Ceci se répète une troisième fois avec la couche diélectrique D31, le niveau de métallisation sélective SM3, la couche diélectrique D32, et le plan de masse PM4.

Avantageusement, ceci se répète une quatrième fois avec la couche diélectrique D41, le niveau de métallisation sélective SM4, la couche diélectrique D42 et le plan-masse supérieur PM5, qui est ici illustré à une certaine distance au-dessus de la couche diélectrique D42 (dans le seul but d'améliorer la lisibilité du dessin).

Des trous métallisés tels que MH0 traversent complètement la structure de part en part, pour aller du plan-masse PM1 au plan-masse PM5, en se reliant à chaque fois aux plans-masse intermédiaires PM2, PM3, PM4.

D'autres trous métallisés, tels que MH14, MH24 ou MH34 relient des niveaux de liaisons conductrices l'un à l'autre.

Dans ce second cas, les trous métallisés ne viennent en principe pas au contact des plans-masse, sauf là où c'est désiré. Ainsi par exemple, le trou métallisé MH14 relie une ligne conductrice du niveau SM1 à une ligne conductrice du niveau SM4.

Le trou métallisé MH24 relie une ligne du niveau SM2 à une ligne du niveau SM4. Et le trou métallisé MH34 relie une ligne du niveau SM3 à une ligne du niveau SM4.

La dernière des couches diélectriques, ici la couche D42, est échancrée pour définir un dégagement, qui découvre le niveau sous-jacent de liaisons conductrices. Chaque dégagement est conformé en fonction, notamment, de la géométrie du ou des composants électroniques et/ou de la puce d'élément actif à loger. La définition de la conformation des dégagements est ici considérée comme accessible à l'homme du métier.

L'alimentation de la puce, et/ou de tout autre composant, peut provenir d'un autre niveau de liaison de l'empilement, atteint par des trous métallisés. Certaines au moins des entrées, sorties, ou entrées/sorties de la puce, par exemple, peuvent également provenir d'un niveau inférieur de liaison, au moins là où des croisements de liaisons sont nécessaires.

Ainsi, la figure 2 illustre dans l'échancrure ou dégagement E une puce MMIC qui comporte trois bornes d'entrées/sorties reliées par fil soudé ("ball bonding") à des lignes conductrices que l'on distingue en SM4-1 à SM4-6. L'alimentation est assurée par une liaison sur une autre ligne SM4-7, tandis que la masse de la puce est ici définie par son fond relié au conducteur sous-jacent SM-9 par une colle conductrice. En variante, la masse peut être amenée par une autre connexion latérale.

La figure 2 fait encore apparaître des trous métallisés traversants indiqués en MH0.

La structure qui vient d'être décrite peut être considérée comme la combinaison de quatre systèmes tri-plaques ("stripline") superposés, à laquelle sont incorporées d'une manière nouvelle les puces actives et/ou des éléments passifs d'une technologie différente.

Il apparaît que les deux ou trois niveaux sous-jacents permettent de réaliser les interconnexions voulues, tant pour la borne active d'alimentation que pour les lignes de signal, sans qu'il soit nécessaire de donner un exemple détaillé de telles interconnexions. Les entrées/sorties du circuit (signal et/ou alimentation) peuvent être définies par un ou plusieurs connecteurs latéraux (non représentés). Ces connecteurs peuvent être montés comme les composants, le cas échéant.

De préférence, le matériau diélectrique est celui connu sous le nom de Duroïd 6002 (mélange verre/céramique/téflon), dans une épaisseur de 0,127 mm par exemple, vendu par la Société Rogers Corporation. Ce matériau possède une constante diélectrique de 2,9 à 10 Ghz, pour un facteur de dissipation de 0,013 à la même fréquence. Ces coefficients de dilatation thermique sont de 16 ppm/°K dans les directions X et Y, c'est-à-dire dans son plan, contre 24 ppm/°K dans la direction Z, c'est-à-dire perpendiculairement à son plan.

La Demanderesse a observé qu'il est possible d'utiliser ce matériau pour réaliser des lignes de transmission de largeur 100 µm et espacées les unes des autres de 100 µm, ces dimensions étant ajustables selon l'impédance désirée. Les trous traversants peuvent être réalisés à un diamètre de 0,3 mm, pour se relier à des métallisations dont la taille mimimale est celle du diamètre du trou augmentée de 0,3 mm.

La Demanderesse a encore observé que le matériau résiste très bien à des cycles nombreux de variations rapides de températures.

Il a encore été observé que, pour assurer dans des conditions correctes le perçage et la métallisation, le diamètre des trous doit être au moins égal à environ 1/5ème de l'épaisseur des couches traversées.

C'est alors qu'il a été remarqué que le dispositif proposé, plus spécialement avec le matériau qui vient d'être indiqué, peut conduire à une structure particulièrement compacte, ce qui présente des avantages manifestes dans le domaine des hyperfréquences.

Il a encore fallu résoudre le problème de la réalisation matérielle du dispositif.

Le point de départ consiste en des couches de Duroïd 6002, dont l'épaisseur est par exemple de 0,127, ou de 0,254 mm. Ces couches sont munies d'une métallisation de cuivre dont l'épaisseur est de 35 µm, par exemple.

Plusieurs structures identiques peuvent être réalisées dans un même panneau, qui est ensuite découpé.

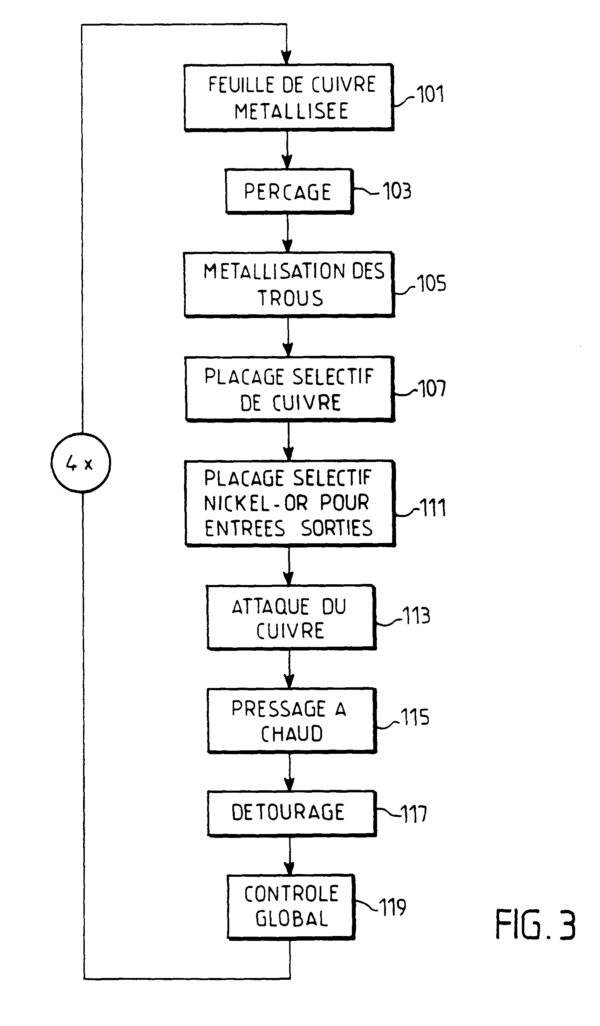

La figure 3 illustre la suite des étapes du procédé de fabrication, pour chacune des structures tri-plaques que comprend le dispositif.

L'étape 101 part d'une feuille de cuivre métallisée du type de celle définie précédemment.

L'étape 103 consiste en son perçage aux endroits voulus.

L'étape 105 consiste en la métallisation des trous.

L'étape 107 consiste en une recharge sélective de cuivre ("pattern plating"), ajoutant par exemple au moins 25 µm aux 35 µm de cuivre déjà déposés.

L'étape 111 consiste en un placage, par exemple un placage sélectif avantageusement de nickel-or, pour réaliser les métallisations, au niveau notamment des dégagements, en vue des connexions aux entrées/sorties des puces et du circuit.

L'étape 113 consiste dans l'attaque du cuivre, aux endroits voulus soit pour laisser place aux trous traversants, soit pour assurer les lignes de transmission.

L'étape 115 consiste en un pressage à chaud (autoclave à environ 380°C), pour assurer la liaison à haute température des couches, qui se lient par fusion. Comme on le verra plus loin, cette étape peut être effectuée différemment.

L'étape 116 consiste en un détourage de l'extérieur du circuit et des emplacements de puces et/ou autres composants. Ce détourage est effectué par exemple à la fraise ou par usinage au laser.

A l'étape ultime 119, un contrôle global est effectué sur le sandwich tri-plaque qui vient d'être obtenu, l'ensemble du processus étant répété quatre fois pour obtenir le dispositif de la figure 1.

En principe, le placage électrolytique au nickel et à l'or est effectué non seulement pour les entrées/sorties, mais aussi pour les plots de soudure par fil de la puce.

Des métallisations latérales de blindage peuvent également être effectuées sur les côtés de la structure, en même temps que les trous métallisés et avant qu'elle ne soit découpée en circuits individuels, et/ou du côté de l'entrée/sortie. Des métallisations sélectives de blindage peuvent également être envisagées sur les faces qui délimitent les dégagements, perpendiculairement aux couches.

Les échancrures ou dégagements destinés à recevoir les puces et/ou les composants passifs sont découpées a priori (avant le pressage de l'étape 115) dans la couche diélectrique supérieure de l'élément tri-plaque supérieur. De telles échancrures ou dégagements permettent de loger par exemple des composants passifs de type résistance, capacité, induction, filtre interdigité, mélangeur à diodes, ou bien des puces miniatures actives, hyperfréquence ou non, par exemple à base d'arséniure de gallium, ou encore d'un ASIC de commande, qui sont directement fixés par une colle époxy conductrice pour micro-électronique (comme la colle H20E de la société EPOTECNY des Etats-Unis), sur une zone munie d'une métallisation épaisse de 70 µm ou bien d'une couche locale isolante de type céramique. Dans le cas d'une métallisation épaisse, deux trous aveugles placés sous la puce permettent la connexion de masse.

La soudure par fil sur les bornes de la puce est effectuée après la polymérisation de la colle. On utilise de préférence un procédé de soudure thermosonique à l'or ("Thermosonic gold ball bonding"), avec un diamètre de fil de 25 µm.

Une variante consiste à effectuer une soudure par ruban thermosonique de 75 µm de large, ce qui peut autoriser une boucle plus courte et une inductance plus faible.

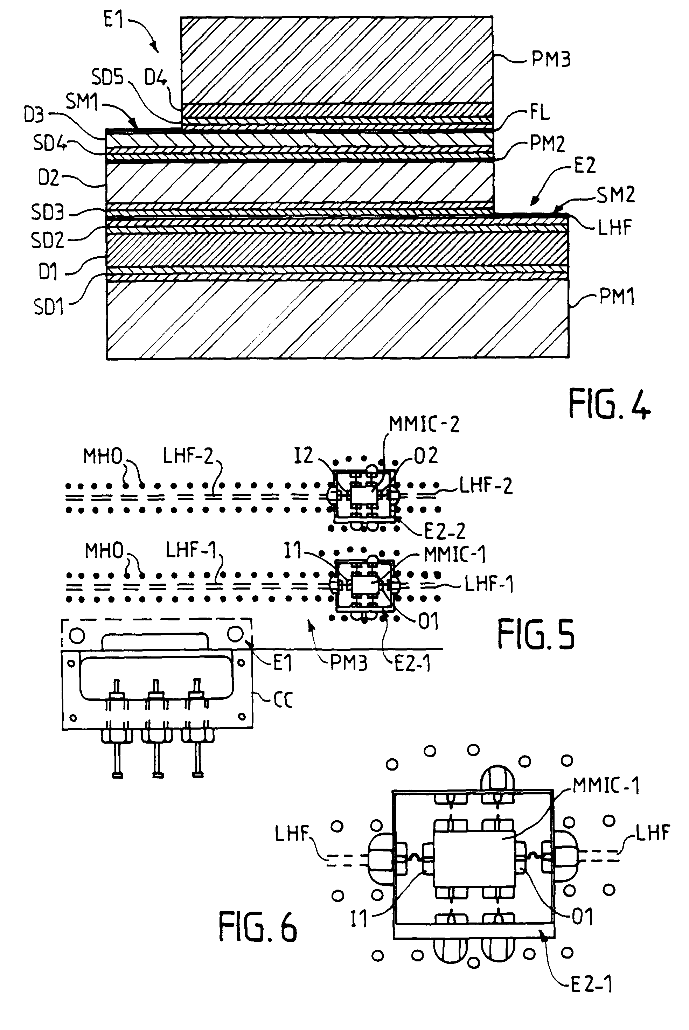

La figure 4, qui décrit un second mode de réalisation de l'invention, sera maintenant décrite, de bas en haut.

Contrairement au premier mode de réalisation qui décrit un circuit hyperfréquence destiné à être implanté dans un boîtier, le second mode décrit un circuit hyperfréquence dont les couches inférieure PM1 et supérieure PM3 externes constituent les parois supérieure et inférieure d'un boîtier qui est de préférence en aluminium. Un tel boîtier constitue alors un dispositif "tout intégré", dans la mesure ou ses parois de protection font partie intégrante de la structure du circuit qu'il "loge".

Une première couche diélectrique D1 repose sur la paroi inférieure en aluminium PM1 qui joue le rôle d'un plan-masse, avec interposition d'une première couche diélectrique de collage SD1 pour renforcer le collage entre la face supérieure de PM1 et la face inférieure de D1. Entre la couche D1 et une seconde couche diélectrique D2 sont intercalées, tout d'abord, une seconde couche diélectrique de collage SD2, puis une première liaison conductrice LHF, de préférence de type feuillard "Oméga foil" (structure à deux couches superposées de cuivre et de NiP), puis une troisième couche diélectrique de collage SD3, SD2 et SD3 étant destinées à assurer le collage, d'une part, entre la face supérieure de D1 et la face inférieure de LHF, et d'autre part, entre la face inférieure de D2 et la face supérieure de LHF.

Entre la couche D2 et une troisième couche diélectrique D3 sont intercalées, tout d'abord, un second plan-masse PM2, de préférence en cuivre, puis une quatrième couche diélectrique de collage SD4 destinée à assurer le collage entre la face inférieure de D3 et la face supérieure de PM2.

Dans ce mode de réalisation, on peut également prévoir (même si cela n'est pas représenté sur le figure 4) des trous métallisés, tels que ceux référencés MH0 sur la figure 1, qui traversent complètement la structure de part en part, pour aller du plan-masse inférieur (ou paroi inférieure du boîtier) PM1 au plan-masse supérieur (ou paroi supérieure du boîtier) PM3, en se reliant éventuellement au plan-masse intermédiaire PM2.

Entre la face supérieure de D3 et une quatrième couche diélectrique D4 sont intercalées, tout d'abord, une seconde liaison conductrice FL destinée à l'alimentation et de préférence en cuivre, puis une cinquième couche diélectrique de collage SD5 destinée à assurer le collage entre la face inférieure de D4 et la face supérieure de FL. Enfin, la paroi supérieure du boîtier en aluminium PM3, qui joue le rôle d'un plan-masse, repose sur la face supérieure de D4. Une telle structure est donc, comme dans le premier mode de réalisation, de type tri-plaque (ou stripline).

Bien entendu, on peut prévoir d'intercaler d'autres couches diélectriques de collage, notamment entre PM3 et D4, et/ou entre FL et D3, et/ou entre PM2 et D2.

Le circuit présente, dans sa partie supérieure, une première échancrure locale E réalisée dans sa dernière couche diélectrique D4, la cinquième couche diélectrique de collage SD5 et la paroi supérieure PM3 du boîtier, et dans sa partie inférieure, une seconde échancrure locale E2 réalisée au travers de l'ensemble des couches situées au dessus de la ligne hyperfréquence LHF, y compris la paroi supérieure PM3.

Ces échancrures définissent des dégagements qui découvrent les liaisons conductrices. Chaque dégagement est conformé en fonction, notamment, de la géométrie du ou des éléments, actifs et/ou passifs, hyperfréquence ou non, qu'il doit accueillir. Ainsi, le premier dégagement El peut être agencé pour recevoir des moyens de connexion CC (voir figure 5) destinés à relier le boîtier à une alimentation, tandis que le second dégagement E2 peut être agencé pour recevoir, par exemple, une puce d'élément actif hyperfréquence ou un ASIC de commande (et/ou un ou plusieurs composants électroniques passifs). Comme dans le premier mode de réalisation décrit précédemment, il est considéré que la définition de la conformation des dégagements est accessible à l'homme du métier.

Une partie au moins des échancrures El et E2 présente une métallisation SM1 ou SM2, réalisée, par exemple, par placage d'une couche de nickel de 5 à 10 µm, puis d'une couche d'or de 3 à 5 µm, pour faciliter la connexion du composant prévu à la liaison conductrice concernée, par exemple par soudage, brasage ou collage.

Comme dans le premier mode de réalisation, le matériau diélectrique utilisé pour réaliser les quatre couches. diélectriques D1 à D4 est, de préférence, le Duroïd 6002 (mélange verre/céramique/téflon).

La Demanderesse s'est aperçue que le matériau de collage qui permettait de réaliser un circuit présentant le plus petit écart entre les caractéristiques théoriques et les caractéristiques réellement obtenues, était un matériau dit "préimprégné" réalisé par exemple à base de fibres de téflon expansé dans une matrice cyanate-ester. Un tel matériau est commercialisé par la Société GORE sous la référence Speed-board M. Ses propriétés diélectriques et son coefficient de dilatation en Z permettent son utilisation comme matériau de collage pour la réalisation de circuits multicouches hyper-fréquences. Ce matériau thermodurcissable peut supporter des températures supérieures à 250°C, et par conséquent des pressages successifs à chaud peuvent être réalisés sans que la structure soit altérée.

Un empilement tel que décrit ci-avant est particulièrement adapté, d'une part, à la réalisation de circuits par des dispositifs qui ne peuvent pas effectuer un pressage à une température supérieure à 350°C (de type autoclave), et d'autre part, à l'élaboration de circuits multicouches à résistances intégrées.

En effet, les résistances planaires intégrées réalisées jusqu'à présent ne peuvent pas supporter des températures élevées, typiquement 380°C, lesquelles sont nécessaires au pressage à chaud de type autoclave.

En revanche, les résistances planaires réalisées par attaque locale d'endroits prédéterminés de la couche supérieure en cuivre du feuillard Oméga foil, au voisinage d'une ligne de transmission supportent des températures de l'ordre de 300°C.

Or, la Demanderesse s'est aperçue qu'il était possible de réaliser, par pressage à 275°C, une structure multicouche munie de lignes de transmission, et notamment hyperfréquence, équipées de résistances planaires, en "sandwichant" des feuillards de type Oméga foil entre des couches de collage de type pré-imprégné.

Cette étape d'assemblage des couches, par pressage, est donc légèrement différente de l'étape 115 dont il est question dans le premier mode de réalisation, puisqu'elle s'effectue à plus basse température (275°C, environ, au lieu de 380°C).

Les autres étapes (101 à 113, 116 et 119) sont en revanche sensiblement identiques à celles du premier mode de réalisation.

Un exemple, non limitatif, de réalisation d'un circuit du type décrit ci-dessus est donné ci-dessous.

PM1 et PM2 sont des couches d'aluminium d'environ 0,8 mm. Les couches diélectriques D1, D2, D3 et D4 sont réalisées en Duroïd 6002 d'épaisseur respectives 0,508 mm, 0,381 mm, 0,127 mm et 0,127 mm. Chaque couche diélectrique de collage (SD1 à SD5) est réalisée en préimprégné GORE d'épaisseur 0,127 mm et leur face inférieure respective supporte une couche de cuivre de forme adaptée et d'épaisseur 0,0175 mm.

On se réfère maintenant aux figures 5 et 6.

La figure 5 illustre, en vue du dessus, une partie d'un boîtier hyperfréquence "tout intégré" dont la structure est identique à celle illustrée figure 4.

Cette partie de boîtier comprend deux puces MMIC-1 et MMIC-2 respectivement implantées dans des dégagements E2-1 et E2-2, et connectées chacune à une ligne hyperfréquence LHF-1 et LHF-2, respectivement. Le boîtier est alimenté au niveau d'un connecteur CC qui est implanté dans le dégagement E1. dans l'exemple illustré, le dégagement E1 n'a été réalisé que partiellement, car la couche supérieure PM3 d'aluminium est toujours présente, seules les couches D4 et SD3 ont été localement attaquées. Le connecteur CC est par conséquent inséré entre FL et PM3. Bien entendu, le dégagement El peut être également réalisé dans le plan-masse supérieur PM3.

Dans cet exemple, on a prévu une pluralité de trous métallisés MH0, reliant les plans-masse PM1 à PM3, autour des lignes hyperfréquences LHF-i afin de les isoler des perturbations électromagnétiques. De préférence, l'espacement entre lesdits trous est sensiblement égal au quart de la longueur d'onde de fonctionnement de la structure.

Une vue agrandie de l'implantation de la puce MMIC-1 dans l'échancrure E2-1 de la figure 5 est illustrée sur la figure 6. La puce MMIC-1 comporte notamment une borne d'entrée I1 et une borne de sortie O1 connectées respectivement à la ligne hyperfréquence LHF-1, soit directement par contact sur les métallisations SM2 (non représentées), soit par fil soudé ("ball bonding"). La puce MMIC-1 n'étant pas placée au niveau de la ligne d'alimentation FL, son alimentation peut être effectuée par un trou métallisé (non représenté), du type de ceux représentés sur la figure 1, qui relie FL au plan contenant la ligne hyperfréquence LHF-1. De même, la masse flottante de la puce MMIC-1 peut être amenée par une autre connexion latérale reliée par trou métallisé à l'un des plans-masse PMi.

Une multiplicité de composants électroniques actifs ou passifs, hyperfréquence ou non, peuvent ainsi être intégrés dans un même boîtier, lequel sera conçu en fonction des besoins.

La réalisation de ce type de boîtier hyperfréquence, est sensiblement identique à celle de la structure illustrée figure 1. La seule réelle différence consiste à déposer des parois épaisses d'aluminium formant les plans-masse PM1 et PM3, ce qui est réalisé lors de l'assemblage initial des couches de la structure.

Dans le second mode de réalisation, on a décrit un assemblage comportant des couches diélectriques de collage, mais il est clair que l'on peut se passer de celles-ci lorsque la structure ne comporte pas de résistances intégrées, les liaisons entre couches s'effectuant alors par fusion lors de l'étape de chauffage à 380°C.

Par ailleurs, dans le premier mode de réalisation on a décrit un assemblage de couches diélectriques réalisé sans couches de collage, mais on peut envisager d'utiliser les mêmes couches de collage que celles décrites dans le second mode de réalisation lorsque le dispositif d'assemblage des couches par pressage à chaud ne peut atteindre des températures supérieures à environ 350°C.

De même, on pourrait envisager un premier mode de réalisation dans lequel les plans-masse supérieur et inférieur seraient formés par les parois d'un boîtier, comme dans le second mode de réalisation.

Enfin, on peut parfaitement envisager une superposition de plusieurs structures selon le premier ou le second mode de réalisation décrit ci-avant (et leurs variantes), dans le but de réaliser une structure à multi-niveaux de lignes de transmission et/ou d'alimentation.

Les structures telles que celles qui viennent d'être décrites, avec les matériaux indiqués, possèdent de très bons résultats en termes de performances électriques et de contraintes dimensionnelles. Comme déjà indiqué, ceci constitue un pas important vers la solution du problème posé.

## Revendications

1. Circuit hyperfréquence, du type comprenant un empilement de couches diélectriques, avec au moins une couche conductrice formant plan-masse, tandis que sont prévues des liaisons conductrices, en au moins un niveau d'interface entre couches diélectriques,
caractérisé en ce que l'empilement contient plusieurs plans-masse (Pmi), alternés avec au moins deux niveaux de liaisons conductrices (SM;LHF,FL), chaque niveau de liaisons conductrices se trouvant ainsi pris en sandwich entre deux plans-masse (PM),
en ce qu'est prévu au moins un premier dégagement (E;E2) découvrant un niveau de liaisons conductrices et conformé pour loger opérativement au moins un composant électronique passif et/ou une puce d'élément actif (MMIC), dont la ou les entrées/sorties et l'alimentation proviennent de niveaux intermédiaires de liaisons conductrices de l'empilement, atteints par des trous métallisés (MH) qui traversent des plans-masse au niveau d'épargnes de ceux-ci.

2. Dispositif selon la revendication 1, caractérisé en ce que les couches diélectriques (D) sont réalisées dans un matériau thermoplastique.

3. Dispositif selon la revendication 2, caractérisé en ce que le matériau thermoplastique est une résine fluorocarbonée, du type verre polytétrafluoroéthylène (PTFE) ou éthylène-propylène fluoré (FEP), et de préférence de type 6002.

4. Dispositif selon l'une des revendications 1 à 3, caractérisé en ce qu'il comprend en outre au moins un second dégagement (E1) découvrant un niveau de liaison conductrice différent du niveau découvert par le premier dégagement (E2) et conformé pour loger opérativement des moyens (CC) de connexion à une alimentation, destinée à alimenter une puce d'élément actif (MMIC) par des trous métallisés qui traversent des plans-masse au niveau d'épargnes de ceux-ci.

5. Dispositif selon l'une des revendications 1 à 4, caractérisé en ce qu'entre au moins chaque face supérieure de liaison conductrice (LHF,FL) et une face inférieure de chaque couche diélectrique (D2,D4) superposée respectivement sur chacune desdites liaisons conductrices, et entre chaque face supérieure de plan-masse de niveau intermédiaire (PM2) et une face inférieure de chaque couche diélectrique (D3) superposée respectivement sur chacun desdits plans-masse intermédiaires, on prévoit une couche de collage (SD) en résine fluorocarbonée du type dit "préimprégné".

6. Dispositif selon l'une des revendications 1 à 5, caractérisé en ce qu'il comprend deux niveaux de liaisons conductrices (LHF,FL), pris en sandwich entre trois plans-masse (PM1-PM3), dont un plan-masse inférieur (PM1), un plan-masse intermédiaire (PM2) et un plan-masse supérieur (PM3).

7. Dispositif selon la revendication 6, caractérisé en ce que les plans-masse supérieur (PM2) et inférieur (PM1) sont respectivement des parois supérieure et inférieure d'un boîtier métallique, de préférence en aluminium.

8. Dispositif selon l'une des revendications 1 à 5 et 7, caractérisé en ce qu'il comprend au moins trois niveaux de liaisons conductrices (SM1-SM4), pris en sandwich entre quatre plans-masse (PM1-PM5).

9. Dispositif selon l'une des revendications 4 à 8, caractérisé en ce que des faces délimitant les dégagements, perpendiculairement au plan des couches, présentent une métallisation.
